# DEMANDE DE BREVET EUROPEEN

(11) **EP 2 706 445 A1**
(43) Date de publication de la demande: **12.03.2014**
(21) Numéro de dépôt: 13192772.5
(22) Date de dépôt: 06.08.2010
(51) Int. Cl.: G06F 3/044

(54) **Dispositif de detection capacitif à intégration de fonctions**

(30) Priorité: 07.08.2009 FR 0955584
(62) Demande divisionnaire de: 10762732.5
(71) Demandeur: Nanotec Solution, 30900 Nîmes (FR)
(72) Inventeur: Roziere, Didier, 30900 Nîmes (FR)
(74) Mandataire: Pontet Allano & Associes

(57) **Abrégé**

La présente invention concerne un dispositif d'interface de commande capacitif comprenant :
- au moins une électrode de mesure comportant une surface active,
- une garde en matériau électriquement conducteur disposée à proximité de ladite ou desdites électrodes de mesure, laquelle garde est excitée à un potentiel électrique alternatif sensiblement identique à celui des électrodes de mesure,
- des premiers moyens électroniques pour exciter la ou les électrodes et traiter les signaux de mesure issus du couplage capacitif de ladite ou desdites électrodes avec un objet disposé à proximité, lesquels moyens électroniques sont au moins pour partie référencés au potentiel électrique de la garde.

Ce dispositif de mesure comprend en outre des seconds moyens électroniques pour réaliser un affichage, disposés à proximité de ladite surface active, et au moins pour partie référencés au potentiel électrique de la garde.

## Description

### Domaine technique

La présente invention concerne un dispositif capacitif pour détecter un corps ou un objet dans un espace de détection, permettant l'intégration d'autres fonctions électroniques. Ce dispositif capacitif peut notamment être un dispositif d'interface de commande, notamment gestuelle et/ou tactile possiblement combinée à une commande vocale, sensible à un mouvement d'un corps ou d'un objet ou à la voix. Elle vise également un procédé de contrôle d'environnement mis en oeuvre dans ce dispositif, ainsi qu'un équipement de commande mettant en oeuvre un tel dispositif.

Le domaine de l'invention est plus particulièrement mais de manière non limitative celui des interfaces homme-machine, gestuelles et/ou tactiles, et possiblement vocales, permettant en temps réel d'interpréter des mouvements du corps, de la main, du doigt ou d'un objet, à grande distance jusqu'au toucher, ces mouvements étant combinés ou non à une requête vocale afin d'exécuter une ou des commandes.

### Etat de la technique antérieure

De plus en plus, on recherche dans les interfaces virtuelles une fonction de détection de proximité, qui permet de créer de nouveaux modes d'interactions homme-machine sans aucun contact. Les capteurs doivent alors être en mesure de détecter des déplacements ou des formes à plusieurs centimètres de manière suffisamment précise et résolue pour pouvoir les transformer en commandes.

Plus généralement, les interfaces hommes-machines dites virtuelles, c'est à dire gestuelles et/ou tactiles et vocale, par opposition aux interfaces où l'utilisateur agit sur des capteurs mécaniques tels que des touches de clavier ou des commutateurs, sont le plus souvent des cameras 3D lorsqu'il s'agit d'interface gestuelle et des surfaces actives, souvent transparentes et intégrées sur des écrans d'affichage lorsqu'il s'agit d'interface tactile. Ces interfaces tactiles sont largement répandues sous le nom de « touchpad » pour de multiples applications industrielles et grand public, comme par exemple sur les smartphones, en domotique ou les interfaces de jeux.

L'écran permet d'afficher par exemple un clavier ou l'interface d'un logiciel dont l'image évolue en réponse aux actions de l'utilisateur, qui consistent en général en un déplacement, un tapotement ou encore un contact prolongé du doigt ou d'un stylet sur la surface de l'écran afin d'exécuter des commandes.

Plus récemment se sont développées les interfaces dites gestuelles pour répondre à la complexité de plus en plus grande des produits numériques issus de la convergence des technologies de l'information de la communication et du divertissement. Ces interfaces sont le plus souvent à base d'une camera 3D et d'un traitement d'image capable d'interpréter à grande distance, jusqu'à 5 mètres, les mouvements du corps ou de la main pour interagir avec l'écran.

Parmi les commandes virtuelles il faut aussi citer la commande vocale qui permet l'exécution d'une requête à partir de la voix

Parmi les technologies tactiles existantes, les technologies capacitives sont fréquemment utilisées car :
- elles ne nécessitent pas d'exercer une action mécanique sur la surface de l'écran contrairement à des techniques résistives par exemples,
- elles se prêtent bien au maillage de la surface de l'écran par un réseau de capteurs directement intégré à la surface de ce dernier, ce qui permet une intégration bien plus compacte et robuste qu'avec des techniques optiques par exemple qui nécessitent un réseau d'émetteurs-récepteurs surélevés par rapport à la surface de détection.

De plus en plus, on recherche dans les interfaces virtuelles une fonction de détection de proximité, qui permet de créer de nouveaux modes d'interaction homme-machine sans aucun contact. Les capteurs doivent alors être en mesure de détecter des déplacements ou des formes à plusieurs centimètres, de manière suffisamment précise et résolue pour pouvoir les transformer en commandes.

Si les technologies optiques sont incontournables quand il s'agit de détecter précisément les mouvements à très grande distance (au delà de 40 centimètres), les technologies capacitives s'avèrent très bien adaptées pour les interfaces sans contact de proximité, notamment parce que l'ensemble des capteurs peut être intégré à une surface active non plane, par exemple un écran, sans zone morte ou sans nécessiter de dispositifs externes (caméras).

Parmi les interfaces tactiles capacitives, les techniques les plus utilisées sont en général basées sur le principe du transfert de charges. Elles permettent d'obtenir une sensibilité de l'ordre du picofarad mais ne sont pas adaptées pour réaliser une interface gestuelle. En effet, leur sensibilité ne permet pas de détecter l'approche d'un doigt car la capacité générée ne dépasse alors pas quelques centièmes de picofarads. Les capacités parasites présentes dans ce type de capteur et dans l'électronique empêchent toute amélioration de la sensibilité.

De plus, ces techniques sont très sensibles aux perturbations électromagnétiques, aux charges électriques parasites et à la conduction électrique du diélectrique recouvrant les électrodes. Lorsque l'humidité relative de l'air est supérieure à 60%, la plupart des diélectriques deviennent légèrement conducteurs d'électricité et les charges générées par l'électronique sont modifiées, ce qui perturbe la mesure capacitive.

Parmi les solutions techniques employées pour réaliser des interfaces non tactiles capacitives, on en connait qui mettent en oeuvre une pseudo-garde permettant de réduire fortement les capacités parasites dans le capteur et l'électronique. Ces techniques permettent toutefois de ne gagner au mieux qu'un ordre de grandeur sur la sensibilité, ce qui permet de détecter la présence d'un doigt à seulement quelques mm de la surface sensible du capteur.

En ce qui concerne les interfaces gestuelles capacitives, on connait le document US 6,847,354 par Vranish, dans lequel des capteurs capacitifs avec garde active sont mis en oeuvre. Cette garde active est créée à l'aide d'un amplificateur de gain unitaire qui génère dans la garde une tension d'une amplitude identique à celle de l'électrode de mesure.

L'inconvénient de cette méthode est que l'électronique génère par principe physique des capacités parasites qui correspondent à la somme des capacités d'entrée de l'amplificateur pour générer la garde active, appelée aussi pseudo garde, et du circuit pour exciter l'électrode de mesure. Ces capacités parasites atteignent facilement le picofarad et se rajoutent à la capacité à mesurer, qui peut ne représenter que le centième de cette valeur totale.

De plus, la mesure de la capacité n'est pas directe car l'électronique de Vranish obtient l'image de la capacité à mesurer en mesurant son courant via une résistance de référence. Cette résistance génère un déphasage parasite du courant électrique qui dégrade fortement la qualité de détection ou de démodulation du signal représentant la capacité à mesurer. Un autre inconvénient est le niveau de diaphonie entre les différentes électrodes. En effet, chaque électrode est excitée par un amplificateur opérationnel dont le gain est approximativement unitaire. Le moindre écart de gain entre les différents amplificateurs provoque une importante capacité parasite supplémentaire.

Ces inconvénients ne permettent pas de détecter et de repérer la position d'un objet comme un doigt ou une main à plusieurs centimètres voire dizaines de centimètres avec chaque capteur.

Par ailleurs, les technologies capacitives mises en oeuvre pour la réalisation d'interfaces gestuelles ont été développées le plus souvent dans le but d'être intégrées à des écrans ou du moins des surfaces sensiblement planes. Les structures de capteurs sont matricielles, comme dans US 6,847,354, et interfacées par des structures d'électrodes disposées selon une grille X-Y. Ces technologies se prêtent difficilement à l'instrumentation de surfaces de formes plus complexes.

En particulier, elles sont difficilement applicables à des dispositifs de commandes virtuelles ou des interfaces gestuelles basés non pas sur une surface plane instrumentée mais sur d'autres types de géométries incluant des cavités, des reliefs, des ondulations simulant par exemple des touches, des boutons ou enveloppant l'utilisateur dans lesquels des capteurs peuvent être disposés selon des géométries diverses, parfois sous des matériaux diélectriques d'épaisseur importante, et doivent parfois pouvoir être disposés et gérés indépendamment les uns des autres.

Plus généralement, les dispositifs capteurs pour interfaces virtuelles se présentent habituellement sous la forme d'une matrice de détection fixée sur la face avant d'un écran de visualisation dont l'affichage évolue en fonction des actions de l'utilisateur. L'électronique de contrôle de l'écran se trouve à l'arrière du capteur, et les électrodes de mesures sont protégées des perturbations électriques par la garde active.

Le domaine d'application de ces interfaces virtuelles ne se limite pas à l'instrumentation d'écrans mais peut être avantageusement étendu à l'équipement de claviers, panneaux, etc. de formes diverses qu'on peut regrouper sous l'appellation de surfaces actives. Il est alors souhaitable d'intégrer des fonctions supplémentaires à ces surfaces actives, comme par exemple un éclairage, des dispositifs de rétroaction tactiles, des affichages, pour confirmer un ordre de commande ou accompagner l'utilisateur.

L'intégration de ces fonctions électriques au niveau des électrodes capacitives, sans dégrader la mesure capacitive, est une difficulté majeure. Dans les dispositifs de l'art antérieur, ces fonctions ne peuvent être réalisées qu'au moyen de circuits électriques et électroniques référencés à une masse électrique identique à celle de l'objet cible. En conséquence, tous ces circuits sont vus par les électrodes capacitives également comme des objets cibles, qui perturbent et dégradent fortement la sensibilité du capteur capacitif.

On connaît le document FR 2,884,349 par Rozière, qui divulgue un système basé sur des capteurs capacitifs comportant une seule électrode de mesure. Ce système permet de détecter des objets au delà de 10 cm avec chaque électrode, grâce à une électronique à pont flottant. Les mesures des électrodes sont lues séquentiellement au moyen d'un système de scrutation. Toutefois, ce système, destiné à équiper des parois d'instruments mobiles, est spécifiquement conçu pour couvrir les applications d'anticollision, et ne couvre pas des applications d'interface gestuelle. Dans le but de limiter au maximum les capacités parasites sources de perturbations, cette électronique a la particularité de comprendre une partie flottante référencée au potentiel alternatif de la garde, qui est identique à celui de l'électrode.

Le but de la présente invention est de proposer un dispositif capacitif pour détecter un corps ou un objet dans un espace de détection, apte à intégrer des fonctions complémentaires au niveau des électrodes sans que les performances de la mesure capacitive soient notablement affectées.

### Exposé de l'invention

Cet objectif est atteint avec un dispositif de détection capacitif comprenant :
- au moins une électrode de mesure comportant une surface active,
- une garde en matériau électriquement conducteur disposée à proximité de ladite ou desdites électrodes de mesure, laquelle garde est excitée à un potentiel électrique alternatif sensiblement identique à celui des électrodes de mesure,
- des premiers moyens électroniques pour exciter la ou les électrodes et traiter les signaux de mesure issus du couplage capacitif de ladite ou desdites électrodes avec un objet disposé à proximité, lesquels moyens électroniques sont au moins pour partie référencés au potentiel électrique de la garde.

Suivant l'invention, ce dispositif de détection comprend en outre :
- des moyens pour réaliser une autre fonction, disposés à proximité de ladite surface active, et
- des seconds moyens électroniques prévus pour contrôler lesdits moyens de réalisation d'une autre fonction, lesquels seconds moyens électroniques sont au moins pour partie référencés au potentiel électrique de la garde.

Avantageusement, le traitement des signaux de mesure peut fournir des informations de distance entre la surface active des électrodes et l'objet.

Les objets détectables avec un dispositif selon l'invention sont des objets détectables de manière capacitive, c'est-à-dire sensiblement conducteurs d'électricité et aptes à constituer une masse électrique. Ces objets ne sont pas nécessairement reliés à la masse par une connexion électrique, mais ils peuvent l'être naturellement par couplage capacitif. On peut citer, à titre d'exemples non limitatifs, un être vivant, une main, un doigt, ou un stylet en matériau conducteur tenu à la main.

Suivant un aspect particulièrement avantageux du dispositif selon l'invention, l'électronique à pont flottant décrite dans FR 2,756,048 (les premiers moyens électroniques) est modifiée de telle sorte à intégrer des fonctions électroniques supplémentaires (les seconds moyens électroniques) référencées au potentiel de garde. Ainsi, les composants électroniques réalisant ces fonctions peuvent être physiquement intégrés à proximité immédiate des électrodes de mesure sans perturber la mesure car, étant au potentiel de la garde, ils sont « vus » par les électrodes comme s'ils étaient partie intégrante de la garde. Ce mode d'implémentation n'est évidemment possible que lorsque l'électronique de contrôle des capteurs capacitifs comporte une partie totalement flottante, ce qui n'est pas le cas dans les autres dispositifs. Ainsi, par exemple dans US 6,847,354, la garde est mise sensiblement au même potentiel que les électrodes au moyen d'un amplificateur de gain unitaire, mais ce dernier est référencé comme tout le reste de l'électronique à la masse générale.

Un dispositif selon l'invention peut comporter une pluralité d'électrodes de taille suffisante pour obtenir la distance de détection souhaitée. Ces électrodes peuvent être protégées à l'arrière par un écran de garde maintenu à un potentiel électrique sensiblement identique à celui des électrodes, afin de limiter ou de supprimer toute les capacités parasites pouvant se superposer à la capacité crée entre l'objet visé et les électrodes. Cette garde est générée par une électronique dite flottante qui a la particularité de générer une garde extrêmement efficace. Ainsi l'électronique ne mesure que la capacité générée entre l'objet cible et l'électrode sans être gêné par les capacités parasites qui existent dans le capteur et dans l'électronique, et la portée et la sensibilité du dispositif peuvent être particulièrement importantes.

Suivant des modes de réalisation particuliers, les premiers moyens électroniques peuvent comprendre des moyens de scrutation permettant de lire séquentiellement les signaux de mesure issus des électrodes de mesure. Les électrodes qui ne sont pas en cours de scrutation peuvent avantageusement être reliées au potentiel de la garde.

Dans ce mode de réalisation, les électrodes sont sélectionnées séquentiellement afin de limiter le nombre de composants et la consommation d'énergie. Le fait de relier au potentiel de garde les électrodes qui ne sont pas en cours de scrutation permet de réduire au maximum les effets de bord électrostatique de l'électrode mesurante.

Suivant d'autres modes de réalisation nécessitant plus de composants, chaque électrode peut être reliée à un circuit électronique comme par exemple un amplificateur de charge. Ces circuits électroniques sont référencés au potentiel électrique flottant, donc à celui de la garde, ce qui permet de conserver la propriété avantageuse que chaque électrode est vue comme une garde pour ses voisines. Cette solution permet d'augmenter la vitesse de mesure car les capacités ou distances peuvent être mesurées en parallèle sur toutes les électrodes.

Il est bien entendu possible de mettre en oeuvre d'autres modes de scrutation des électrodes, tel que par exemple une lecture par groupe.

Suivant des modes de réalisation particuliers, les moyens électroniques peuvent comprendre des moyens permettant de regrouper électriquement des électrodes de mesure, de telle sorte que ces électrodes regroupées constituent une électrode de mesure unique.

Il est ainsi possible de créer des électrodes de surface supérieure, permettant d'augmenter l'étendue de mesure pour détecter des objets à une plus grande distance. La configuration des groupements d'électrodes peut bien entendu être effectuée électroniquement. Les électrodes de mesure peuvent par exemple être regroupées lorsque l'objet est loin du dispositif afin de privilégier la portée de mesure, et dégroupées lorsque l'objet est proche des électrodes afin de favoriser la résolution spatiale et la précision de la position en trois dimensions de l'objet.

Suivant des modes de réalisation particuliers,
- les moyens électroniques référencés au potentiel électrique de la garde peuvent être alimentés par une alimentation électrique comprenant au moins l'un des éléments suivants : convertisseur DC/DC, self de choc,
- les seconds moyens électroniques peuvent comprendre des moyens de découplage, de telle sorte qu'à la fréquence du potentiel électrique alternatif d'excitation de la garde, ils apparaissent comme étant sensiblement à ce même potentiel.

L'électronique capacitive flottante est basée sur le principe qui consiste à alimenter au moins une partie de l'électronique avec une tension flottante. Cette tension peut être générée par exemple par un convertisseur de tension continu-continu (DC/DC) qui possède une bonne isolation galvanique. Elle peut également être générée en couplant une alimentation au travers de selfs de chocs (appelées aussi bobines d'arrêt) qui, à la fréquence d'excitation du capteur, se comportent comme des impédances élevées isolant la partie flottante de la masse de référence de l'objet cible, tout en laissant passer le courant continu pour alimenter le circuit électronique flottant.

Lorsqu'on rajoute des fonctions électriques comme par exemple un éclairage par diodes électroluminescentes (LED), un affichage à cristaux liquide (LCD) à proximité des électrodes, ou un quelconque capteur de mesure (optique...), il est nécessaire de relier ces circuits au même potentiel de garde que le capteur capacitif afin d'éviter toute perturbation capacitive.

En effet, si de tels circuits électriques étaient référencés par exemple au potentiel de masse extérieur (potentiel proche de celui de l'objet ou du doigt), les lignes de champ des électrodes seraient très rapidement absorbées par ces circuits et la portée des électrodes ne permettrait pas de réaliser une détection sans contact. Pour alimenter ces circuits additionnels, on peut par exemple utiliser le même convertisseur DC/DC ou la même alimentation découplée par des selfs de choc que pour l'électronique flottante des capteurs capacitifs, ou rajouter un ou plusieurs convertisseur DC/DC en prenant soin de relier les sorties zéro volts de tous les convertisseurs entre elles.

Pour assurer un fonctionnement optimal, il est préférable que tous les potentiels des circuits électriques rajoutés soient parfaitement référencés au potentiel de garde. Pour cela, il faut que tous les circuits électroniques qui gèrent ces nouvelles fonctions soient équivalents à des générateurs de Thevenin (c'est-à-dire à des sources de tensions pures) à la fréquence d'excitation du capteur. Ainsi il ne peut y avoir de fuites capacitives entre le capacimètre flottant (c'est-à-dire le circuit d'interface des électrodes de mesure capacitives) et les autres fonctions. On peut par exemple pour cela utiliser des circuits à impédance de sortie de faible valeur, ou insérer des capacités de découplage.

Par exemple, dans le cas d'une diode électroluminescente (LED) commandée par un circuit numérique classique, une des pattes de la LED est reliée à la garde tandis que la deuxième est reliée à la sortie du circuit numérique de commande. Ce circuit de commande est en lui-même sensiblement équivalent à un générateur de Thevenin. Par précaution, on peut également ajouter une capacité de découplage en parallèle avec la LED, afin de supprimer toute tension résiduelle à la fréquence d'excitation à ses bornes.

Avec ce principe, il est même possible de gérer des fonctions complexes et consommatrices d'énergie comme un écran LCD, un moteur électrique, une caméra, un éclairage, ou des fonctions de mesure comme une sonde de température.

La partie flottante de l'électronique peut communiquer avec des systèmes externes référencés par exemple à la masse générale au travers de moyens de découplage. Ces moyens de découplage peuvent comprendre par exemple des amplificateurs différentiels, des optocoupleurs ou des selfs de choc.

Suivant un aspect avantageux du dispositif selon l'invention, ces fonctions électroniques supplémentaires peuvent être utilisées comme garde au niveau des électrodes de mesure. En effet, étant référencées à la garde, non seulement elles ne perturbent pas la mesure capacitive, mais en plus elles permettent d'augmenter la surface équivalente de la garde au niveau du capteur capacitif, ce qui contribue à améliorer la portée et/ou la sensibilité des électrodes de mesure. Il devient alors possible de placer des fonctions du côté de la partie mesurante (la face active) des électrodes.

Suivant des modes de réalisation particuliers,
- au moins une partie des moyens électroniques référencés au potentiel électrique de la garde peut être intégrée sur le même support que les électrodes de mesure,
- au moins une partie des moyens électroniques référencés au potentiel électrique de la garde peut être disposée sensiblement dans un plan constitué par la surface active d'au moins une partie des électrodes de mesure,
- le dispositif selon l'invention peut comprendre un support de type circuit imprimé, dont une face comprend des électrodes de mesure et l'autre face comprend une garde,
- le circuit imprimé peut être souple ou rigide, avec une forme adaptée à des mises en oeuvre particulières,
- le dispositif selon l'invention peut comprendre un matériau diélectrique disposé du côté de la surface active des électrodes de mesure,
- les seconds moyens électroniques peuvent comprendre au moins un élément parmi un moyen d'indication et un moyen de mesure.

Ces moyens électroniques additionnels peuvent en effet comprendre tout aussi bien des capteurs destinés à collecter des informations complémentaires aux mesures capacitives, que des actuateurs ou autres dispositifs destinés à fournir une information à l'utilisateur ou adapter l'aspect de l'interface.

Avantageusement, à titre d'exemples non limitatifs, les seconds moyens électroniques peuvent comprendre au moins un élément parmi :
- un moyen d'illumination à base de diodes électroluminescentes,
- un afficheur à base de cristaux liquides (LCD) ou de diodes électroluminescentes organiques (OLED),
- un moyen de rétroaction tactile piézoélectrique,
- un indicateur sonore,
- un capteur d'imagerie optique de type CCD ou CMOS,
- un capteur de température,
- un capteur d'humidité,
- un capteur de pression atmosphérique,
- un capteur de luminosité de type photodiode.

Un dispositif selon l'invention permet d'équiper toute sorte de machine en mouvement ou de contrôler son déplacement par rapport à son environnement. Il permet aussi de déterminer la position ou les mouvements d'une personne.

Suivant un autre aspect, il est proposé un équipement de commande assurant une fonction d'interface homme-machine intégrant un dispositif selon l'invention.

Cet équipement de commande peut se présenter sous la forme d'un panneau de contrôle plan, ou d'une forme quelconque permettant une intégration optimisée pour obtenir un maximum d'esthétique ou d'ergonomie. Il peut être par exemple d'une forme sphérique ou demi sphérique pour imiter une souris d'ordinateur. Il permet de remplacer tous ou une partie des boutons électromécaniques de commande, par exemple pour des raisons de fiabilité et de design.

Il est possible avec un dispositif selon l'invention de mesurer sans contact la position d'un doigt ou d'un objet dans l'espace jusqu'à plusieurs centimètres, ainsi que de détecter le contact et la pression du doigt ou de l'objet sur panneau de commande ou un clavier, et ce même au travers d'un diélectrique quelconque.

Le panneau de commande peut être équipé d'actuateur pour donner un retour physique d'action. Ces actuateurs peuvent être aussi reliés au potentiel de garde.

Il est ainsi possible de réaliser des claviers virtuels, adaptatifs, donnant à l'utilisateur une perception très évoluée, futuriste et ergonomique avec des possibilités de combinaison de commande originales. Ces claviers peuvent être réalisés dans une grande variété de matériaux diélectriques offrant par exemple des qualités de toucher particulières.

En général, les électrodes sont juxtaposées les unes aux autres afin d'éviter des zone mortes sur le panneau. On peut aussi créer volontairement des zones mortes où l'électrode est remplacée par une garde ou une autre fonction comme une LED.

On peut par exemple placer une LED au centre de chaque électrode capacitive afin d'indiquer à l'utilisateur ou se trouve chaque électrode. Cette LED peut s'allumer dés que l'électronique détecte à une certaine distance l'approche d'un doigt ou d'un quelconque objet.

On peut aussi rajouter un écran LCD ou OLED. Tous ces circuits électriques et composants sont référencés au même potentiel que celui de l'électronique capacitive, ce qui élimine le risque de perturber le fonctionnement des électrodes.

Suivant un autre aspect, il est proposé un procédé de contrôle d'environnement mettant en oeuvre un dispositif selon l'invention, comprenant une mesure d'au moins une distance entre un objet et des électrodes de mesure capacitives disposées à proximité d'une garde excitée via une première électronique à un potentiel électrique alternatif sensiblement identique à celui desdites électrodes de mesure, **caractérisé en ce qu'il** comprend en outre une réalisation d'une fonction supplémentaire mettant en oeuvre une seconde électronique dont au moins une partie est reliée au potentiel électrique de ladite garde.

La fonction supplémentaire peut notamment :
- être déterminée au moins à partir des mesures de distances,
- comprendre au moins une interaction parmi la lecture d'un moyen de mesure et l'activation d'un moyen d'indication.

Avantageusement, le procédé peut comprendre en outre une étape de détermination de commandes, lesquelles commandes sont conditionnées par au moins par l'une des actions suivantes :
- mesure de distances entre les électrodes de mesure et l'objet, et
- lecture de seconds moyens électroniques.

Le procédé et le dispositif permettent ainsi, à titre d'exemples non limitatifs, de détecter l'approche d'un utilisateur, notamment le type d'utilisateur et le mode d'approche, et d'éclairer sélectivement les parties du tableau de commande vers lesquelles il se dirige ou auxquelles il est utilisé à accéder. L'utilisateur peut être identifié en utilisant également d'autres capteurs que les capteurs capacitifs (caméra). L'éclairage peut également être ajusté en fonction de la luminosité ambiante mesurée. Des capteurs de mesures de grandeurs physiques peuvent être activés et interrogés uniquement lorsque les capteurs capacitifs détectent le passage d'un objet.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre la structure des lignes de champ électrique d'un capteur capacitif triaxial, selon une disposition représentative de l'art antérieur,
- la figure 2 illustre la structure des lignes de champ électrique d'un capteur capacitif triaxial auquel on a rajouté un composant externe relié à la masse général à proximité de l'électrode de mesure, selon une disposition représentative de l'art antérieur,
- la figure 3 illustre un premier mode de réalisation de dispositif selon l'invention mettant en oeuvre un capteur capacitif triaxial,
- la figure 4 illustre un second mode de réalisation de dispositif selon l'invention mettant en oeuvre un capteur capacitif triaxial,
- la figure 5 illustre un premier mode de réalisation de dispositif selon l'invention mettant en oeuvre une matrice de capteurs capacitifs,
- la figure 6 illustre un second mode de réalisation d'un dispositif selon l'invention mettant en oeuvre une matrice de capteurs capacitifs.

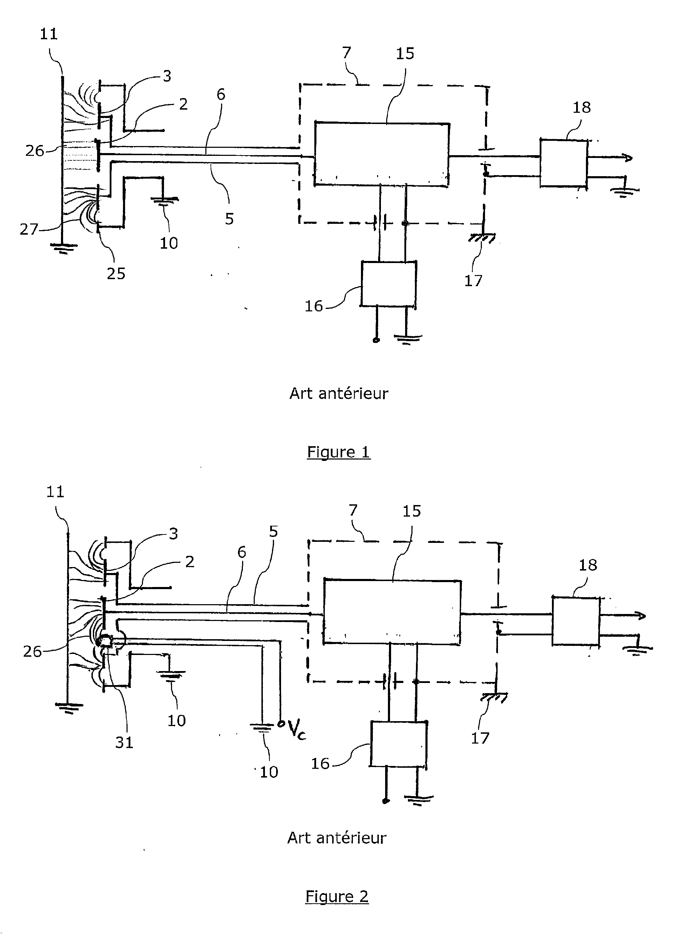

La figure 1 présente un capteur capacitif triaxial contrôlé par une électronique à pont flottant telle que décrite dans le document de l'art antérieur FR 2,756,048. Le capteur capacitif comprend une électrode de mesure 2 et une électrode de garde 3. Il comprend également une masse 25. La masse 25 est reliée à la masse générale 10, qui peut être la terre. L'électrode de mesure 2 est reliée par un conducteur 6 à un circuit d'excitation et de mesure de la capacité, ou capacimètre, 15. Le capacimètre 15 mesure la capacité entre l'électrode 2 et un objet 11 couplé avec la masse générale 10.

La particularité de l'électronique à pont flottant décrite dans FR 2,756,048 est qu'elle comporte une partie 7 flottante et référencée au potentiel 17 de la garde 3 à laquelle elle est connectée par un conducteur 5. De préférence, les conducteurs 5, 6 ainsi que la masse 25 sont regroupés sous la forme d'un câble triaxial dans lequel les conducteurs sont disposés de manière concentrique. La garde 3 est excitée à un potentiel électrique alternatif à fréquence fixe par l'électronique 7. L'électrode de mesure 2 est également maintenue à ce même potentiel. La partie flottante 7 de l'électronique est alimentée par un convertisseur de tensions continues DC/DC 16 référencé du côté de sa sortie au potentiel de garde 17. Les signaux de mesure sortant du capacimètre 15 sont transférés à l'électronique référencée à la masse générale 10 par un amplificateur différentiel 18.

La garde 3 protège l'électrode 2 des influences électriques extérieures précisément parce qu'elle est maintenue au même potentiel que cette dernière. Il n'y a pas de couplage capacitif en la garde 3 et l'électrode 2 et les lignes de champ électrostatique 26 issues de l'électrode 2 restent orientées bien perpendiculairement à la surface de cette dernière, ce qui permet d'optimiser la sensibilité du capteur donc sa portée. En cas de couplage capacitif, comme par exemple entre la garde 3 et la masse 25, les lignes de champ électrostatique 27 deviennent fortement incurvées.

La figure 2 illustre le cas, représentatif de l'art antérieur, de ce qui se passe lorsque l'on introduit à proximité de l'électrode capacitive 2 un composant 31 référencé à la masse générale 10. Dans l'exemple de la figure 2, une LED 31 est ajoutée entre l'électrode de mesure 2 et la garde 3. Cette LED 31 est pilotée par un circuit électronique extérieur référencé à la masse générale 10, qui lui applique une tension Vc pour l'allumer.

Le trajet naturel des lignes de champ électrostatique issues de l'électrode 2 est dévié par la LED 31 qui est à la même masse que l'objet 11 pour la fréquence d'excitation et se comporte donc comme une cible parasite. Les lignes de champ 26 de l'électrode 2 sont partiellement attirées par cette LED 31, ce qui réduit fortement sa sensibilité envers la cible 11. Les performances du capteur en sont directement affectées.

Bien entendu, l'exemple de la LED est nullement limitatif et le raisonnement est valable pour tout composant 31 référencé à un potentiel différent de la garde à la fréquence d'excitation.

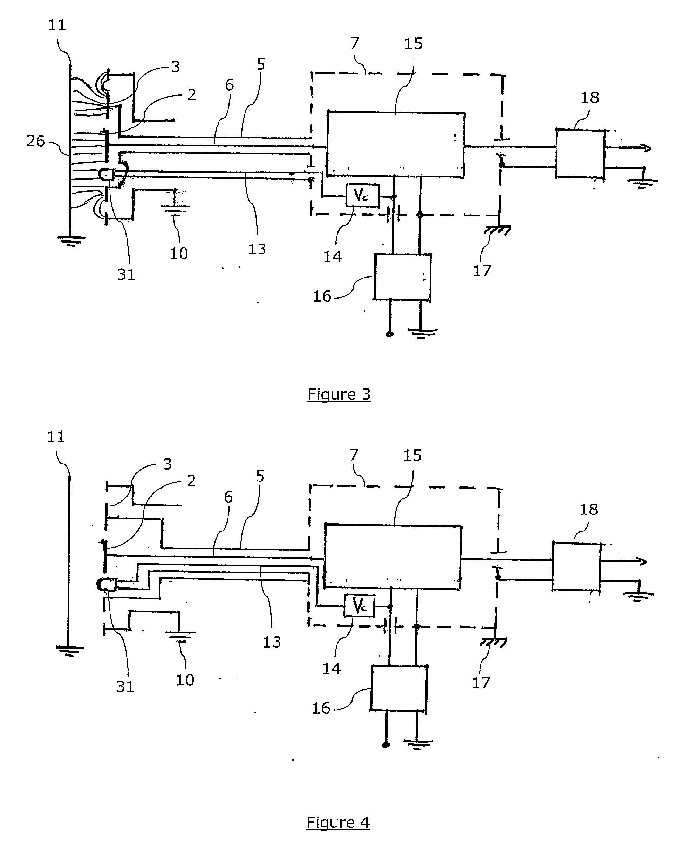

La figure 3 présente un mode de réalisation de dispositif selon l'invention, dans lequel on ajoute une fonction, ici pour l'exemple une LED 31, dans le capteur à proximité de l'électrode 2. Conformément à la présente invention, la LED 31 est reliée par un fil 13 à une électronique de commande 14 qui est flottante et intégrée à la partie 7 de l'électronique référencée au potentiel de la garde. Cette électronique de commande 14 est par exemple un générateur de tension permettant d'allumer la LED. Une capacité de découplage est insérée en parallèle avec la LED 31, afin de supprimer toute tension résiduelle à ses bornes à la fréquence d'excitation. L'électronique de commande 14 peut être alimentée par l'alimentation flottante 16.

Avantageusement, le trajet des lignes de champ électrostatique 26 n'est plus dévié par la LED 31 qui est, pour la fréquence d'excitation, au potentiel de garde 17 et se comporte donc comme un élément de garde 3. Du point de vue de la mesure capacitive, le capteur n'est donc pas affecté par la présence de la LED 31.

La figure 4 présente un autre mode de réalisation de dispositif selon l'invention, dans lequel le câblage 13 de la LED 31 passe dans le câble de liaison du capteur capacitif, qui est dans ce cas un câble triaxial présentant un coeur à plusieurs brins. Ce mode de réalisation illustre les possibilités d'intégration offertes par le dispositif selon l'invention, du fait que les composants supplémentaires ne perturbent plus le capteur. Dans l'exemple de la figure 4, on n'utilise qu'un seul câble de liaison pour le capteur capacitif et la ou les fonctions supplémentaires.

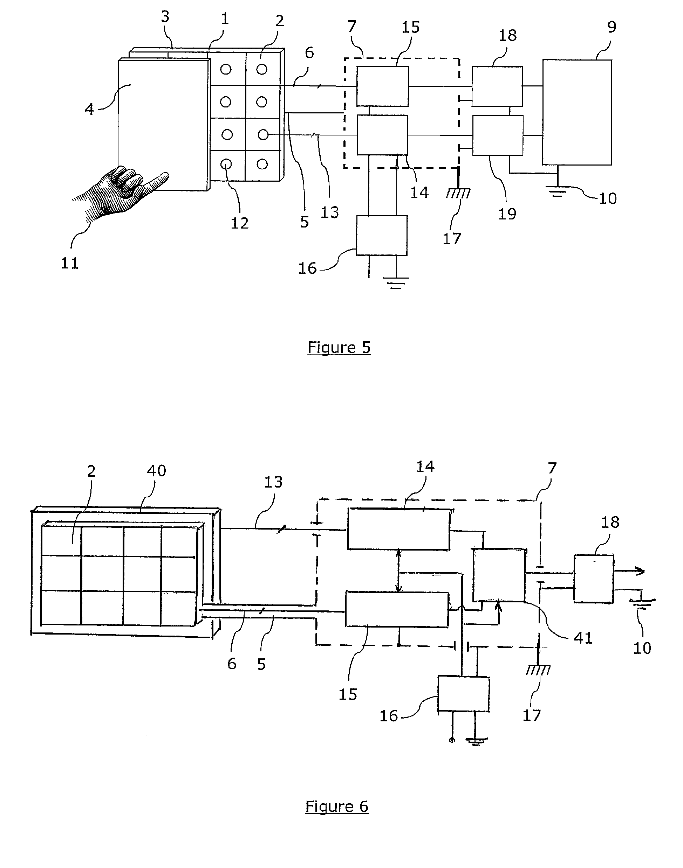

La figure 5 présente un mode de réalisation d'un dispositif selon l'invention comprenant une pluralité de capteurs capacitifs disposés sous forme de matrice. Ce dispositif peut par exemple être utilisé comme panneau de commande. Les capteurs capacitifs sont réalisés sur un circuit imprimé souple double face 1. Les électrodes de mesures 2 sont gravées sur une des faces du circuit imprimé 1, tandis que la deuxième face du circuit supporte une électrode de garde 3. La plaque 1 supporte également des LED 12, disposées au centre des électrodes 2.

Une plaque de matériau diélectrique 4, en silicone par exemple, est placée devant les électrodes 2, de telle sorte à être en contact avec leur surface active.

La plaque 1 est reliée à la partie 7 de l'électronique, qui est flottante par rapport à la masse générale 10 et référencée au potentiel alternatif de la garde 17. L'électrode de garde 3 est reliée à ce potentiel par la liaison électrique 5. Chaque électrode 2 est reliée par une liaison électrique 6 à l'électronique d'excitation et de mesure (ou capacimètre) 15. Les électrodes 2 sont également maintenues au potentiel électrique 17 de la garde. Les LEDs 12 sont reliées à un circuit électronique de pilotage 14 par des liaisons électriques 13. Ces LEDs 12 et leur circuit de pilotage 14 sont également référencés au potentiel électrique de la garde 17.

L'électronique de pilotage et de contrôle des électrodes de mesure capacitives 15, est également décrite dans le document FR 2,756,048. Elle permet de mesurer la distance entre chaque électrode 2 et un objet approchant 11, par mesure du couplage capacitif entre l'électrode 2 et l'objet 11. Cette mesure de distance permet également de détecter le contact entre l'objet 11 et la surface du diélectrique 4, ainsi que l'enfoncement de l'objet 11 dans le diélectrique suite à l'application d'une pression.

Le capacimètre 15 comprend un multiplexeur permettant d'interroger séquentiellement les électrodes 2, tandis que les électrodes inactives sont maintenues au potentiel de garde 17.

La partie flottante 7 de l'électronique est alimentée par au moins un convertisseur de tensions continues DC/DC 16 référencé du côté de sa sortie au potentiel de garde 17. Les signaux de mesure sortant du capacimètre 15 sont transférés au circuit 9 référencé à la masse générale 10 par un amplificateur différentiel 18.

Le circuit de pilotage des LEDs 14 est piloté depuis la partie de l'électronique 9 référencée à la masse générale au travers d'optocoupleurs 19.

La figure 6 présente un autre mode de réalisation d'un dispositif selon l'invention comprenant une pluralité de capteurs capacitifs disposés sous forme de matrice, dans lequel un panneau de commande équipé d'électrodes capacitives 2 transparentes en ITO (oxyde d'indium dopé à l'étain) est placé au dessus d'un écran d'affichage 40. L'écran d'affichage 40 est piloté par une électronique 14 référencée au même potentiel flottant 17 de la garde que le capacimètre 15. Avantageusement, l'affichage 40 apparaît globalement au potentiel flottant de la garde 17 à la fréquence d'excitation, et peut donc être utilisé comme écran de garde 3. On peut donc ainsi déposer directement les électrodes capacitives 2 transparentes au dessus de l'affichage 40 sans dégrader la sensibilité et la portée des capteurs.

Suivant des modes de réalisation particuliers non limitatifs,
- le convertisseur d'alimentation DC/DC 16 peut être remplacé par une alimentation moins onéreuse référencée à la masse générale 10, et couplée au circuit flottant 7 par des « selfs de choc » ou bobines d'arrêt,
- les amplificateurs différentiels de sortie 18 et/ou 19 peuvent être remplacés par des optocoupleurs ou des selfs de choc,
- les signaux entrants, issus de l'électronique 9 référencée à la masse 10 peuvent être transmis aux électroniques 14 de contrôle des fonctions supplémentaires au travers d'optocoupleurs ou de selfs de choc 19.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif d'interface de commande capacitif comprenant :
- au moins une électrode de mesure (2) comportant une surface active,
- une garde (3) en matériau électriquement conducteur disposée à proximité de ladite ou desdites électrodes de mesure (2), laquelle garde est excitée à un potentiel électrique alternatif (17) sensiblement identique à celui des électrodes de mesure (2),
- des premiers moyens électroniques (15, 9) pour exciter la ou les électrodes (2) et traiter les signaux de mesure issus du couplage capacitif de ladite ou desdites électrodes avec un objet (11) disposé à proximité, lesquels moyens électroniques (15) sont au moins pour partie référencés au potentiel électrique (17) de la garde,
**caractérisé en ce qu'il** comprend en outre des seconds moyens électroniques (12, 14, 40) pour réaliser un affichage, disposés à proximité de ladite surface active, et au moins pour partie référencés au potentiel électrique (17) de la garde.

2. Le dispositif de la revendication 1, dans lequel les seconds moyens électroniques comprennent un écran d'affichage (40).

3. Le dispositif de la revendication 2, dans lequel l'écran d'affichage (40) comprend au moins l'un des composants suivants :
- cristaux liquides (LCD)
- diodes électroluminescentes organiques (OLED).

4. Le dispositif de l'une des revendications 2 ou 3, qui comprend une pluralité d'électrodes de mesure (2) placées selon la face avant, au dessus de l'écran d'affichage (40).

5. Le dispositif de la revendication 4, dans lequel les électrodes de mesure (2) sont disposées sous forme de matrice.

6. Le dispositif de l'une des revendications 2 à 5, dans lequel l'écran d'affichage (40) est piloté par des seconds moyens électroniques (14) référencés au potentiel électrique (17) de la garde, et est utilisé comme garde (3).

7. Le dispositif de la revendication 6, qui comprend des électrodes de mesure (2) déposées directement au dessus de l'écran d'affichage (40).

8. Le dispositif de l'une des revendications précédentes, qui comprend des électrodes de mesure (2) transparentes en ITO.

9. Le dispositif de l'une des revendications précédentes, dans lequel les premiers moyens électroniques (15) comprennent des moyens de scrutation permettant de lire séquentiellement les signaux de mesure issus des électrodes de mesure (2), les électrodes qui ne sont pas en cours de scrutation étant reliées au potentiel de la garde (17).

10. Le dispositif de l'une des revendications précédentes, dans lequel les moyens électroniques comprennent des moyens permettant de regrouper électriquement des électrodes de mesure, de telle sorte que lesdites électrodes regroupées constituent une électrode de mesure unique.

11. Le dispositif de l'une des revendications précédentes, dans lequel les seconds moyens électroniques (12, 14, 40) comprennent des moyens de découplage, de telle sorte qu'à la fréquence du potentiel électrique alternatif d'excitation de la garde, ils apparaissent comme étant sensiblement à ce même potentiel.

12. Le dispositif de l'une des revendications précédentes, dans lequel au moins une partie des moyens électroniques référencés au potentiel électrique de la garde (7) est intégrée sur le même support (1) que les électrodes de mesure (2).

13. Le dispositif de l'une des revendications précédentes, dans lequel au moins une partie (12) des moyens électroniques référencés au potentiel électrique de la garde est disposée sensiblement dans un plan constitué par la surface active d'au moins une partie des électrodes de mesure (2).

14. Le dispositif de l'une des revendications précédentes, qui comprend en outre un matériau diélectrique (4) disposé du côté de la surface active des électrodes de mesure.

15. Appareil intégrant un dispositif d'interface de commande de type écran tactile selon l'une des revendications précédentes.

16. Appareil selon la revendication 15 de type smartphone.
